(19) Europäisches Patentamt
European Patent Office
Office européen des brevets

(11) **EP 2 037 492 A1**

(12) **EUROPEAN PATENT APPLICATION**

(43) Date of publication:
**18.03.2009 Bulletin 2009/12**

(51) Int Cl.:
*H01L 21/336* [(2006.01)]   *H01L 29/786* [(2006.01)]

(21) Application number: **07291089.6**

(22) Date of filing: **11.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **S.O.I.TEC Silicon Insulator Technologies**
**38190 Bernin (FR)**

(72) Inventor: **Paul Patruno**
**38100 Grenoble (FR)**

(74) Representative: **Grünecker, Kinkeldey, Stockmair & Schwanhäusser Anwaltssozietät Leopoldstrasse 4 80802 München (DE)**

(54) **Multiple gate field effect transistor structure and method for fabricating same**

(57)   The present invention relates to a Multiple Gate Field Effect Transistor structure with a fin-like structure for forming therein a transistor channel of the Multiple Gate Field Effect Transistor structure, the fin-like structure being formed from at least one active semiconductor layer of a SOI type structure on a buried insulator of said SOI type structure, and a method for fabricating same, said method comprising providing a SOI type substrate comprising at least one active semiconductor layer, a buried insulator and a carrier substrate, and forming from said semiconductor layer a fin-like structure on said insulator, said fin-like structure forming a region for a transistor channel of the Multiple Gate Field Effect Transistor structure. It is the object of the present invention to provide a Multiple Gate Field Effect Transistor structure and a method for fabricating same, wherein the Multiple Gate Field Effect Transistor structure can be near ideally prepared to overcome several related issues. The object is solved by a Multiple Gate Field Effect Transistor structure and a method for fabricating same of the above mentioned type, wherein said insulator comprises at least one high-k layer of a material having a higher dielectric constant than silicon oxide.

Figure 1

EP 2 037 492 A1

## Description

The present invention relates to a Multiple Gate Field Effect Transistor structure with a fin-like structure for forming therein a transistor channel of the Multiple Gate Field Effect Transistor structure, the fin-like structure being formed from at least one active semiconductor layer of a SOI (Silicon On Insulator) type structure on a buried insulator of said SOI type structure, and a method for fabricating same, said method comprising providing a SOI type substrate comprising at least one active semiconductor layer, a buried insulator and a carrier substrate, and forming from said semiconductor layer a fin-like structure on said insulator, said fin-like structure forming a region for a transistor channel of the Multiple Gate Field Effect Transistor structure.

Scaling of device dimensions is a primary factor driving improvements in integrated circuits manufacturing. Due to limitations in scaling gate oxide thickness and source/drain junction depth, scaling of conventional planar MOSFET device beyond the 32 nm process will be difficult if not impossible. Therefore, new device structures like Multiple Gate or Multigate Field Effect Transistors (MuGFET) have been developed to overcome the technological challenges. The Multigate Field Effect Transistor is a MOSFET which incorporates more than one gate into a single device. That means, the channel is surrounded by several gates on multiple surfaces, allowing more suppression of "off"-state leakage current. Multiple gates also enable an enhanced drive current in an "on" state. This leads to lower power consumption and enhanced device performance.

The so-called double-gate MOSFET uses two gates to control the channel what results to the effect that short-channel effects can be greatly suppressed. A specific variant of a non-planar double-gate MOSFET is a FinFET consisting of a channel formed in a vertical Si fin controlled by a double-gate formed on both longitudinal sides of the fin. The fin is made thin enough when viewed from above such that the two gates control the entire fully-depleted channel film. Thus, the dimensions of the fin determine the effective channel length of the transistor device. The FinFET is, as a non-planar device, more compact in comparison to conventional planar MOS transistors, enabling higher transistor density and smaller overall microelectronics. In a further implementation consistent with the principles of the invention, a triple-gate MOSFET is provided as another variant. The triple-gate MOSFET (Tri-Gate transistor) is similar to the previously described FinFET structure on which a third gate is added at the top of the fin to complement the two gates formed on both longitudinal sides of the fin.

The FinFET is typically built on a SOI (Silicon On Insulator) substrate, wherein the fin is formed from an active semiconductor layer on top of the SOI substrate. SOI wafers consisting of a carrier substrate, a buried silicon oxide layer and having on top an active semiconductor layer of silicon have recently been used for planar as well as for non-planar CMOS devices with great success. The implementation of the SOI technology allows a continued miniaturization of CMOS devices. Using SOI substrates, lower parasitic capacitances due to isolation from the carrier substrate improving power consumption at matched performance can be achieved.

During preparation of a FinFET from a SOI substrate, the fin is patterned by lithography, such as electron beam lithography, and etched. The fin is mostly finished by a lateral trimming and cleaning steps with the intent to properly size the width of the fin and keep the surface of the fin smooth and free of contamination. This results, however, to a recess or undercut of the fin. If a SOI substrate with a conventional buried insulator of silicon dioxide is used, the recess or undercut is in a vertical direction between about 15 to 20 nm and in a horizontal direction of about 6 to 8 nm on each side of the fin. For comparison, for the 32 nm technology node, a fin width of around 15 to 20 nm must be achieved and a fin height of around 50 to 60 nm for a tri-gate MuGFET structure or taller for a dual-gate muGFET structure is considered as necessary.

Both dimensions of a fin size, the vertical direction (fin height) and the lateral or horizontal direction (fin width), have large impact on drive current performance, short-channel effect and Gate Induced Drain Leakage (GIDL). For example, taller fins provide higher drive current and a reduced fin width improves GIDL. Moreover, as a second feature, the fin profile must be as straight and vertical as possible with all corners rounded to avoid high electrical field locally and to keep GIDL low. That means, with respect to fin height and fin width, the above mentioned undercut values are proportionally very high increasing the risk for the fin to fall off by being severely undercut and weakened.

In summary, the challenge to successfully control small fin dimensions as required by the semiconductor industry and to be able to continue scaling down those dimensions is very high. It is therefore the object of the present invention to provide a Multiple Gate Field Effect Transistor structure and a method for fabricating same, wherein the Multiple Gate Field Effect Transistor structure can be near ideally prepared to overcome several related issues.

The object is solved by a Multiple Gate Field Effect Transistor structure and a method for fabricating same of the above-mentioned type, wherein said insulator comprises at least one high-k layer of a material having a higher dielectric constant than silicon oxide. This has the advantage that the high-k layer underlying the semiconductor layer of the SOI type substrate acts as a better etch stop than silicon oxide during formation and cleaning of the fin resulting in a lower recess and undercut effect on the socket of the fin. This leads to a higher stability of the formed fin and enables a smooth finishing of the fin by etching and cleaning steps. High-k materials are clearly defined in relation to the dielectric constant of silicon dioxide.

In a preferred embodiment of the invention, said insulator comprises at least one silicon nitride layer. Silicon nitride has a higher dielectric constant than silicon dioxide and is therefore especially well suited to act as an etch stop during etch and cleaning of the semiconductor fin. A silicon nitride layer directly under the semiconductor layer from which the fin is formed, results in a minimum vertical recess and fin undercut. However, if silicon nitride is used as insulator material directly under the semiconductor layer of the SOI type substrate, the bottom corner profile of the fin is not rounded but rather tapered, which might lead to undesirable effects for the resulting FET structure.

It is therefore particular advantageous if said insulator comprises a thin silicon oxide layer between the high-k layer and the semiconductor layer of the SOI type substrate. Using this variant of the invention, the silicon oxide layer being above the high-k layer may be etched and trimmed during the formation and cleaning of the fin, wherein the underlying high-k layer functions as an etch stop so that a further undercut of the fin can be prevented. This way, the advantage of rounded corners at the bottom of the fin can be conserved wherein a recess and undercut of the fin during the fabrication process can be minimized. Thus, the combination of the upper oxide and the high-k layer enables an optimized undercut to be obtained automatically underneath the Field Effect Transistor (FET) during etching.

According to another favourite example of the present invention, said insulator comprises a silicon oxide layer between the high-k layer and the carrier substrate of the SOI type substrate. The lower silicon oxide under the high-k layer allows for a good bonding between the high-k layer and the carrier substrate of the SOI type substrate which is, in particular, necessary if the SOI type structure is manufactured by a SmartCut® process using bonding, implantation and cleaving steps to form the SOI type substrate.

It is especially beneficial if said insulator comprises a layer stack consisting of a lower silicon oxide layer, a silicon nitride layer and an upper silicon oxide layer. This idea includes a replacement of the conventionally used buried oxide (BOx) of a SOI structure by a composite oxide-nitride-oxide (ONO) stack as the insulator of the SOI type substrate. This improves not only the definition of the size and the profile of the fin but also enhances the stability of the structure due to a good bonding strength between the lower oxide and the carrier substrate of the SOI type substrate. In particular, by the upper oxide, rounded corners at the bottom of the fin can be realized and, by the use of the underlying silicon nitride layer as a hard etch stop layer, the fin vertical recess can be perfectly controlled when the upper oxide layer, used as a buffer, will be totally removed around the fin, thereby adjusting the upper oxide layer thickness as proposed is the best way to provide optimization for both the profile under the fin and the electrical characteristics of the MuGFET device.

In a favourable configuration of the present invention, said silicon nitride layer is formed with a thickness of 10 to 200 nm. Using such a thickness, the vertical recess at the bottom of the fin can be reduced to about 2 to 4 nm and the horizontal recess can be totally cancelled.

It has been shown as advantageous if said upper silicon oxide layer is formed with a thickness of 2 to 20 nm, preferably with a thickness of 5 to 15 nm, and more preferably with a thickness of 3 to 12 nm. Because the total height of the fin is given by the sum of the thickness of the semiconductor layer used to make the fin plus the thickness of the silicon oxide layer undercut below the fin, the smaller the upper oxide layer the lower is the total fin height variation. On the other hand, a certain thickness of the upper oxide layer is necessary to allow a formation of rounded corners at the bottom of the fin during etching and cleaning steps of the fin fabrication process. The above thickness values of 2 to 20 nm are a compromise between the above mentioned requirements, wherein with the thickness values of 5 to 15 nm a low undercut can be combined with a good roundness of the corners, and thickness values of 3 to 12 nm reduce the undercut optimally wherein the corners are essentially round to provide good FET characteristics.

In a particular example of the invention, said lower silicon oxide layer is formed with a thickness of about 10 to 100 nm. Although not critical for the purpose of the present invention, this thickness range helps to improve the mechanical stability of the resulting MuGFET structure since it assures a good bonding strength between the carrier substrate and the upper part of the MuGFET structure.

According to a beneficial variant of the method of the present invention, said forming of the fin-like structure comprises an over-etch of the insulator. A controlled over-etch can lead to an improved FET structure because it results in an increased undercut below the fin, wherein a larger horizontal recess will help to improve the propagation of the gate electric field under the FET device for a better back-gate effect.

In the following, features and benefits of advantageous embodiments of the present invention are explained exemplarily with reference to the accompanying figures, in which

Figure 1    shows schematically and in principle main parts of a MuGFET structure using a FinFET structure as an example;

Figure 2    shows schematically an example of a sequence of process steps of the method of the present invention;

Figure 3    shows schematically a fin geometry according to a first embodiment of the present invention;

Figure 4　　shows schematically a fin geometry according to a second embodiment of the present invention;

Figure 5　　shows schematically a fin geometry according to a third embodiment of the present invention; and

Figure 6　　shows schematically the fin geometry according to the third embodiment of the present invention shown in Figure 5, whereas the impact of adjusting the thickness of the layer of the upper oxide is shown.

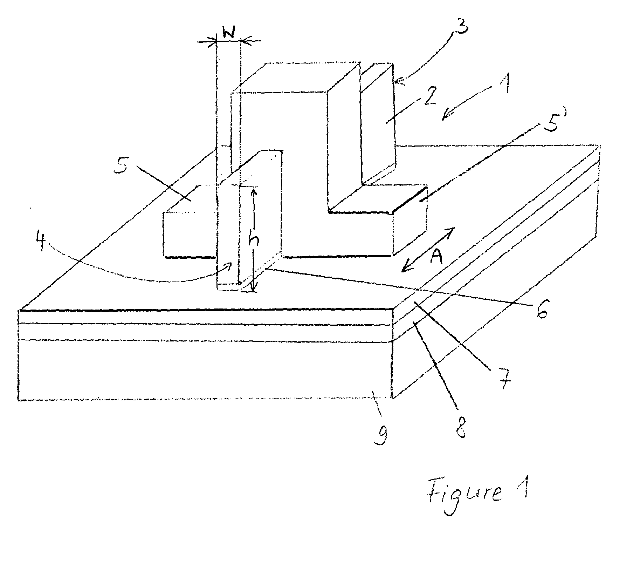

Figure 1 shows schematically and in principle main parts of a MuGFET structure using a FinFET structure 1 as an example. The FinFET 1 comprises a fin-like structure 2 being formed from an active semiconductor top layer of a SOI type substrate. In the example shown, the semiconductor top layer and, therefore, the fin 2 consists of silicon, wherein the fin 2 can consist in other not shown embodiments of the invention of other semiconductor materials like strained silicon, SiGe, SiC, Ge and/or a A(III)-B(V)-compound.

As an improvement, strained silicon can be used to replace the top silicon layer of the SOI type substrate. The use of a strained silicon layer greatly improves electron mobility with (100) orientation of the silicon, thereby providing higher transistor current.

In Figure 1, the height h of the fin 2 is about 50 nm, but can be in other not shown embodiments of the invention between 30 to 100 nm. The width w of the fin 2 is in the example shown about 20 nm and can be in other examples of the invention typically between 10 and 25 nm. The fin 2 is that region of the FinFET in which a conducting channel is formed when the FinFET 1 is in operation. Thus, the dimensions of the fin 2 determine the effective channel length of the FinFET 1.

The ends of the fin 2 in its longitudinal direction A are connected with a source 3 and a drain 4 of the FinFET 1.

On both longitudinal sidewalls of the fin 2, gates 5, 5' are provided. In the example shown in Figure 1, the gates 5, 5' are wrapped around the fin 2.

The present invention can also be applied to produce MuGFET's with multiple drains and multiple sources, such as Tri-Gate FET's, or Gate-All-Around FET's having a similar concept to FinFET's except that the gate material surrounds the channel region on all sides, wherein a Gate-All-Around FET has, depending on design, two or four effective gates. It is also applied to any types of MuGFET's when the gates made are independent-gates and each gate can be electrically activated independently of the others.

The substrate on which the fin 2 of Figure 1 is formed has on top an insulator with a high-k layer having a higher dielectric constant that silicon oxide such as a silicon nitride layer 7. The high-k layer 7 is formed on a lower silicon oxide layer 8, which is on a carrier substrate 9. In the example shown, the carrier substrate 9 is of bulk silicon, but can be in other not shown embodiments of the invention of another material.

As an improvement, the carrier substrate 9 can be a high-resistivity substrate. This way, the resulting MuGFET structures will be able to address Millimeter Wave (MMW) applications and higher frequencies applications up to G band (140 to 220 GHz) for low cost and low power CMOS digital and RF applications.

Between the bottom of the silicon fin 2 and the silicon nitride layer 7, there is a residual part of a former upper silicon layer 6. The upper silicon oxide 6 has in Figure 1 a thickness of about 10 nm, but can have according to other embodiments of the invention a thickness of about 2 to 20 nm, preferably about 5 to 15 nm, and more preferably about 3 to 12 nm.

The silicon nitride layer 7 of Figure 1 has a thickness of 20 nm, which is in other examples of the invention about 10 to 200 nm.

The thickness of the lower silicon oxide layer 8 is for example about 10 to 100 nm, preferably about 70 to 80 nm.

This way, there is layer stack under the fin 2 in Figure 1 consisting of an ONO (oxide/nitride/oxide) structure.

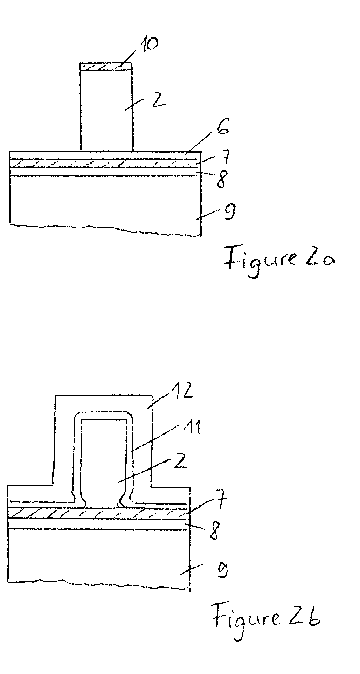

Figures 2a to 2b show schematically a sequence of process steps of the method of the present invention.

With reference to Figure 2a, the method starts with a step of providing a SOI type substrate formed in the example shown by a SmartCut® process and consisting in the example of a the carrier silicon bulk substrate 9, a lower silicon oxide layer 8, a silicon nitride layer 7, an upper silicon oxide layer 6 and an upper silicon layer for forming the fin 2. The silicon layer is covered with a $Si_3N_4$ and $SiO_2$ stack layer 10 and then patterned by electron beam lithography and etch to result in the fin 2.

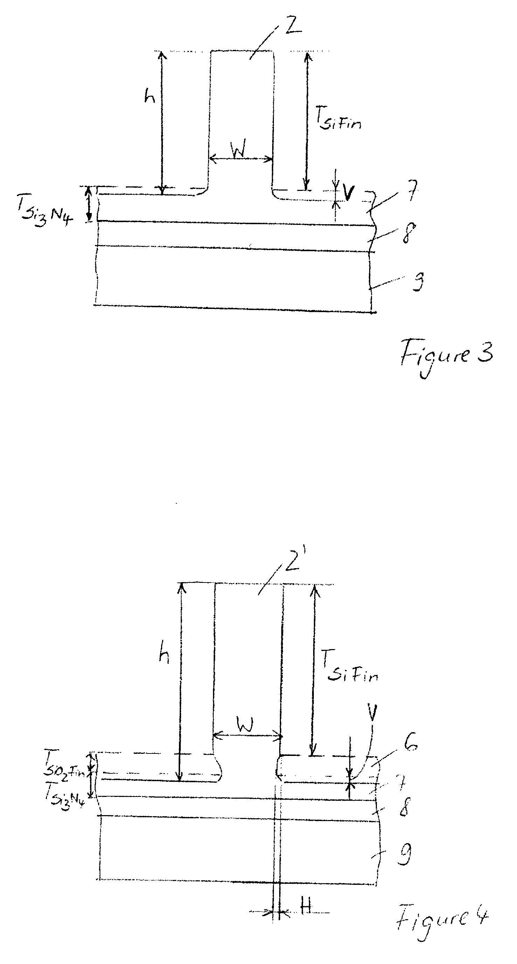

During etching of the fin 2, the underlying silicon oxide layer 6 as well a part of the silicon nitride layer 7 is removed around the fin 2. Due to the etch of the silicon oxide layer 6, the fin 2 is partly underetched. During the formation of the fin 2, the silicon nitride layer 7 acts as an etch stop and shows only negotiable underetch effects under the fin 2, that means, the horizontal recess of the silicon nitride layer 7 is negligible. The result of the etching of the fin is exemplarily shown in Figure 4 explained below.

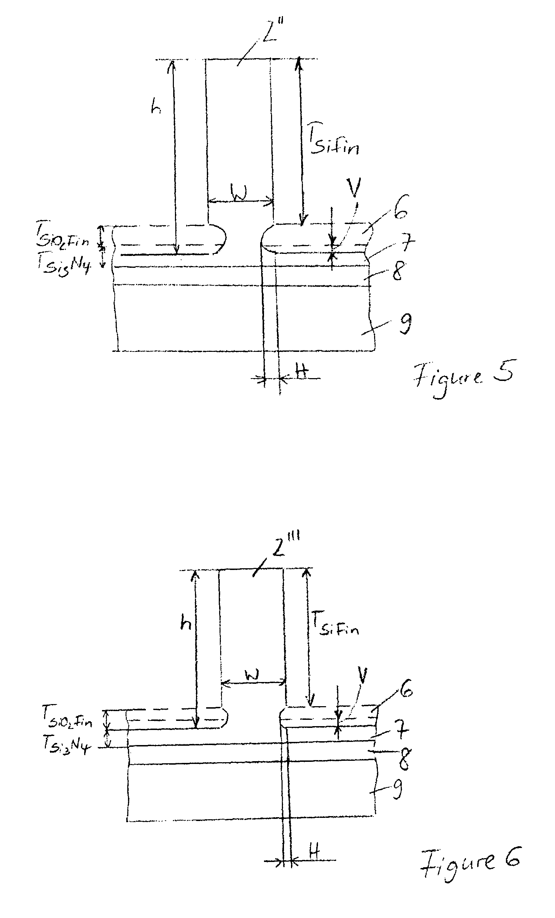

The fin 2 is finished with the trimming and subsequent cleaning of the fin 2 resulting in a larger underetch effect of the silicon oxide layer 6, as shown in Figure 5 described below.

In a next step demonstrated in Figure 2b, an insulating layer 11 is deposited to serve as the future gate oxide. Thereafter, a gate electrode layer 12 of any conductive material is deposited around the insulator layer 11.

The following steps to manufacture a MuGFET device are to be done according the current practice with subsequent steps like completion of the gate stack deposition and gate patterning followed by spacer formation and source/drain formation. The contacts to the transistor regions and other devices are later realized as well as the appropriate number of metal and insulator layers are laid on the wafers and are inter-connected through vias holes together to assemble an integrated circuit.

Figure 3 shows schematically a geometry of a fin 2 according to a first embodiment of the present invention. The fin 2 is formed on the surface of a silicon nitride layer 7 with a thickness of 10 to 30 nm, said silicon nitride layer 7 being formed on top of an oxide layer 8 with a thickness of 70 to 80 nm.

During the formation of the fin 2, the underlying silicon nitride layer 7 acts as an etch stop and reduces, therefore, greatly the vertical recess V and the lateral recess and undercut of the fin 2. According to a particular example, it has been shown that the vertical recess V went to a 2 nm to 4 nm range from about 15 nm and that the horizontal recess was completely reversed. As a consequence of reversing of the profile of the lateral recess or undercut of the fin 2, the bottom corner profile of the fin 2 changes from rounded to tapered which might not be a desirable effect.

Figure 4 shows schematically a geometry of a fin 2' according to a second embodiment of the present invention. The fin 2' is formed on a layer stack consisting of a lower silicon oxide layer 8, a silicon nitride layer 7 and an upper silicon oxide layer 6 formed on top of the layer stack directly under the fin 2'. That means, in comparison to the example shown in Figure 3, the top nitride layer 7 is replaced by the 10 nm to 15 nm range top oxide layer 6. By means of the upper silicon oxide layer 6, the advantage of rounded corners when etching and subsequently cleaning the fin 2' during the fabrication process can be conserved. As shown in Figure 4, there is not only a vertical recess V but also a horizontal recess H in the region under the fin 2', leading to rounded corner formation at the bottom of the fin 2'. Moreover, the used layer structure keeps the benefit of perfectly controlling the fin 2' vertical recess V by using the silicon nitride layer 7 as a hard etch stop when the silicon oxide layer 6, used as a buffer, will be totally removed around the fin 2'.

Figure 5 shows schematically a geometry of a fin 2" according to a third embodiment of the present invention. The fin 2" is an improved variant of the fin 2' of Figure 4. The fin 2" was well controlled over-etched in order to increase the undercut below the fin 2". The larger horizontal recess H helps to round the bottom corners of the fins, which helps to improve the propagation of the gate electric field of the resulting FinFET 1 for a better back-gate effect.

Figure 6 shows the same geometry of the fin 2" according to the third embodiment of the present invention shown in Figure 5, whereas the thickness of the upper silicon oxide layer 6 is reduced by half. This reduces by about the same value the horizontal recess H and helps to achieve a better compromise between recess profile and bottom corner rounding of the resulting fin 2'''.

$$H \sim \tfrac{1}{2}\, T_{SiO2Fin}$$

The total height h variation of the fin 2', 2", 2''' including the vertical recess V on each side of the fin 2', 2", 2''' is given by the sum of the thickness $T_{SiFin}$ of the silicon layer used to make the fin 2', 2", 2''' plus the thickness $T_{SiO2Fin}$ of the silicon oxide layer 6 undercut below the fin 2', 2", 2''' plus the vertical recess V in the silicon nitride layer 7.

$$h = T_{SiFin} + T_{SiO2Fin} + V$$

The variation of the fin height h, knowing that the vertical recess V is very small and varies only within a few tens of nanometer, is therefore predominantly dependent on the control by the manufacturing process of the thickness $T_{SiFin}$ of the silicon layer used to make the fin 2', 2", 2''' and of the thickness $T_{SiO2Fin}$ of the silicon oxide layer 6 being the top layer of the insulator (AlterBOx) of the SOI type substrate used to fabricate the FinFET 1.

This makes the reverse AlterBox process suggested by the present invention far superior for lateral recess and undercut profile control maintaining rounded corners at the bottom of the fin 2', 2", 2''', when compared with the approach shown in Figure 3 where the top layer of the insulator (AlterBOx) of the SOI type substrate is the silicon nitride layer 7. The proposed process still provides a nitride etch-stop layer 7 for a successful control of the vertical total fin height variation.

Moreover, the replacement of the conventional buried oxide layer (BOx) by a composite oxide-nitride-oxide (ONO) as the insulator layer of the SOI type substrate used to fabricate the fin 2', 2", 2''' improves a number of characteristics of the resulting MuGFET structures and may also add with a thin ONO stack the capability to control the substrate potential to adjust, for example, the threshold voltage of the produced transistors.

The MuGFET structures fabricated by the present invention show very good RDF (Random Dopant Fluctuation) due to the lightly doped body, an improved Short-Channel effect due to improved electrostatic behaviour, near-ideal sS (subthreshold Slope) and good DIBL (Drain Induced Barrier Lowering) characteristics. Since it is possible to control by the present invention the fin dimensions and the fin profile, all performance variations of the resulting MuGFET structures can be kept within a tight budget. This will ensure the MuGFET structures of the present invention to provide strong compelling advantages and a continued transistor scaling when compared with planar structures or MuGFET structures formed on conventional SOI substrates.

**Claims**

1. Method for fabricating a Multiple Gate Field Effect Transistor structure (1), comprising
   providing a SOI type substrate comprising at least one active semiconductor layer, a buried insulator and a carrier substrate (9), and
   forming from said semiconductor layer a fin-like structure (2) on said insulator, said fin-like structure (2) forming a region for a transistor channel of the Multiple Gate Field Effect Transistor structure (1),
   **characterized in that**
   said insulator comprises at least one high-k layer of a material having a higher dielectric constant than silicon oxide.

2. Method of claim 1, wherein said semiconductor layer from which the fin-like structure is formed includes at least one layer of silicon, strained silicon, SiGe, SiC, Ge and/or a A(III)-B(V)-compound.

3. Method of claim 1 or 2, wherein said insulator comprises at least one silicon nitride layer (7).

4. Method of one of the preceding claims, wherein said insulator comprises a silicon oxide layer (6) between the high-k layer and the semiconductor layer of the SOI type substrate.

5. Method of one of the preceding claims, wherein said insulator comprises a silicon oxide layer (8) between the high-k layer and the carrier substrate (9) of the SOI type substrate.

6. Method of one of the preceding claims, wherein said insulator comprises a layer stack consisting of a lower silicon oxide layer (8), a silicon nitride layer (7) and an upper silicon oxide layer (6).

7. Method of claim 6, wherein said silicon nitride layer (7) is formed with a thickness ($t_{Si3N4}$) of 10 to 200 nm.

8. Method of claim 6 or 7, wherein said upper silicon oxide layer (6) is formed with a thickness ($t_{SiO2Fin}$) of 2 to 20 nm, preferably with a thickness ($t_{SiO2Fin}$) of 5 to 15 nm, and more preferably with a thickness ($t_{SiO2Fin}$) of 3 to 12 nm.

9. Method of one of the claims 6 to 8, wherein said lower silicon oxide layer (8) is formed with a thickness of about 10 to 100 nm.

10. Method of one of the preceding claims, wherein said forming of the fin-like structure (2) comprises an over-etch of the insulator.

11. Multiple Gate Field Effect Transistor structure (1) with a fin-like structure (2) for forming therein a transistor channel of the Multiple Gate Field Effect Transistor structure (1), the fin-like structure (2) being formed from at least one active semiconductor layer of a SOI type structure on a buried insulator of said SOI type structure,
    **characterized in that**
    said insulator comprises at least one high-k layer of a material having a higher dielectric constant than silicon oxide.

12. Multiple Gate Field Effect Transistor structure of claim 11, wherein said insulator comprises at least one silicon nitride layer (7).

13. Multiple Gate Field Effect Transistor of claim 11 or 12, wherein said insulator comprises silicon oxide (6) between the high-k layer and a part of the fin-like structure (2) being formed from the semiconductor layer of the SOI type substrate.

14. Multiple Gate Field Effect Transistor of one of the claims 11 to 13, wherein said insulator comprises a silicon oxide layer (8) between the high-k layer and a carrier substrate (9) of the SOI type substrate.

15. Multiple Gate Field Effect Transistor of one of the claims 11 to 14, wherein said insulator comprises a stack consisting of a lower silicon oxide layer (8), a silicon nitride layer (7) and an upper silicon oxide (6).

16. Multiple Gate Field Effect Transistor of claim 15, wherein said silicon nitride layer (7) has a thickness ($t_{Si3N4}$) of 10 to 200 nm.

17. Multiple Gate Field Effect Transistor of claim 15 or 16, wherein said upper silicon oxide (6) has a thickness of 3 to 20 nm, preferably a thickness ($t_{SiO2Fin}$) of 5 to 15 nm, and more preferably a thickness ($t_{SiO2Fin}$) of 8 to 12 nm.

18. Multiple Gate Field Effect Transistor of one of the claims 15 to 17, wherein said lower silicon oxide layer (8) has a thickness of about 10 to 100 nm.

Figure 1

10

2

6
7
8

9

Figure 2a

12

11

2

7

8

9

Figure 2b

Figure 3

Figure 4

Figure 5

Figure 6

**European Patent Office**

## EUROPEAN SEARCH REPORT

Application Number

EP 07 29 1089

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/198003 A1 (YEO YEE-CHIA [TW] ET AL) 7 October 2004 (2004-10-07) * the whole document * | 1-18 | INV. H01L21/336 H01L29/786 |
| X | WO 2006/011369 A (NIPPON ELECTRIC CO [JP]; KOH RISHO [JP]; TANAKA KATSUHIKO [JP]; YAMAGA) 2 February 2006 (2006-02-02) * paragraphs [0075] - [0102]; figures 1-5,25 * | 1-18 | |
| X | US 2006/029887 A1 (OH CHANG-WOO [KR] ET AL) 9 February 2006 (2006-02-09) * paragraph [0050]; figure 11 * | 11-18 | |
| X | US 2006/157749 A1 (OKUNO MASAKI [JP]) 20 July 2006 (2006-07-20) * paragraph [0056] - paragraph [0066]; figures 1A-1H * | 1-3,5, 11,12,14 | |
| X | US 2004/195610 A1 (MORIKADO MUTSUO [JP]) 7 October 2004 (2004-10-07) * paragraph [0072] - paragraph [0084]; figures 4-15B * | 1-3,5, 11,12,14 | TECHNICAL FIELDS SEARCHED (IPC) |
| X | US 2006/086977 A1 (SHAH UDAY [US] ET AL) 27 April 2006 (2006-04-27) * paragraphs [0017], [0018] * | 1-3,11, 12 | H01L |

The present search report has been drawn up for all claims

| Place of search | Date of completion of the search | Examiner |
|---|---|---|
| Berlin | 7 November 2007 | Hoffmann, Niels |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 29 1089

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2007

| Patent document cited in search report | | Publication date | Patent family member(s) | | Publication date |
|---|---|---|---|---|---|
| US 2004198003 | A1 | 07-10-2004 | CN SG TW | 1534745 A 115643 A1 594990 B | 06-10-2004 28-10-2005 21-06-2004 |
| WO 2006011369 | A | 02-02-2006 | NONE | | |
| US 2006029887 | A1 | 09-02-2006 | KR | 20060013122 A | 09-02-2006 |
| US 2006157749 | A1 | 20-07-2006 | NONE | | |
| US 2004195610 | A1 | 07-10-2004 | JP US | 2004281782 A 2006244106 A1 | 07-10-2004 02-11-2006 |
| US 2006086977 | A1 | 27-04-2006 | DE KR US WO | 112005002397 T5 20070052337 A 2006214231 A1 2006047116 A1 | 20-09-2007 21-05-2007 28-09-2006 04-05-2006 |

EPO FORM P0459

For more details about this annex : see Official Journal of the European Patent Office, No. 12/82